# EUROPEAN PATENT APPLICATION

(11) **EP 0 810 637 A2**
(43) Date of publication of application: **03.12.1997**
(21) Application number: 97830233.9
(22) Date of filing: 21.05.1997
(51) Int. Cl.: H01L 21/027, H01L 21/3105, H01L 21/321, H01L 21/28

(54) **Method of producing a conductive pattern on a substrate using planarization and etching steps**

(30) Priority: 31.05.1996 IT RM960380
(71) Applicant: TEXAS INSTRUMENTS INCORPORATED, Dallas Texas 75265 (US); TEXAS INSTRUMENTS ITALIA S.p.A., 67051 Avezzano (AQ) (IT)
(72) Inventor: Miccolo, Giuseppe, 67051 Avezzano (AQ) (IT); Russo, Felice, 80030 Cimitile (NA) (IT)
(74) Representative: Taliercio, Antonio

(57) **Abstract**

A method for producing a patterned region on a substrate is disclosed. The method comprises forming an insulating region over a surface of the substrate, forming a first masking region over the insulating region, transferring a pattern that is complementary to the desired patterned region to the first masking region and removing undesired portions of the first masking region, forming a conductive region over said patterned region and over said insulating region in regions corresponding to said removed portions of said first masking region, forming a second masking region over said conductive region, planarizing said second masking region remaining portions of said first masking region and said conductive region to form a substantially planar surface of said substrate, and removing remaining portions of said first masking region thereby leaving only said planarized conductive region.

## Description

This invention broadly relates to manufacturing processes for producing transistors in MOS technology on semiconductor material substrates and more particularly concerns the methods for producing the gate structures of polycrystalline silicon or doped polysilicon in MOS transistors.

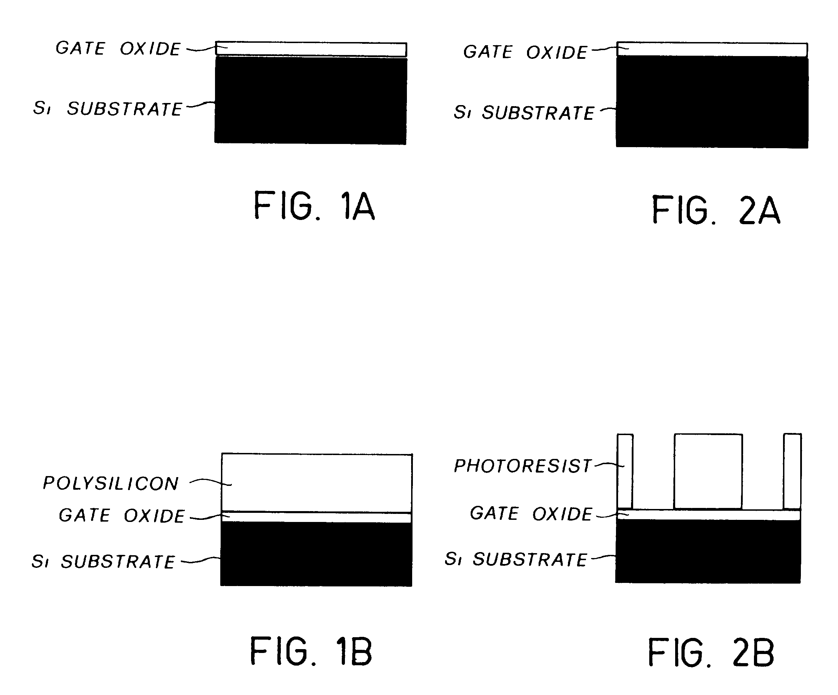

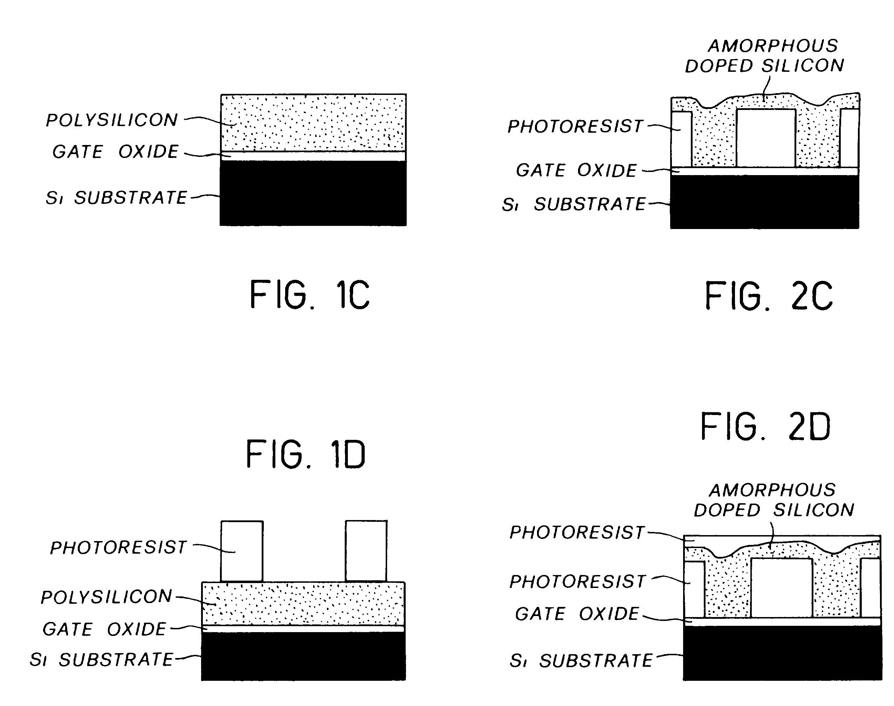

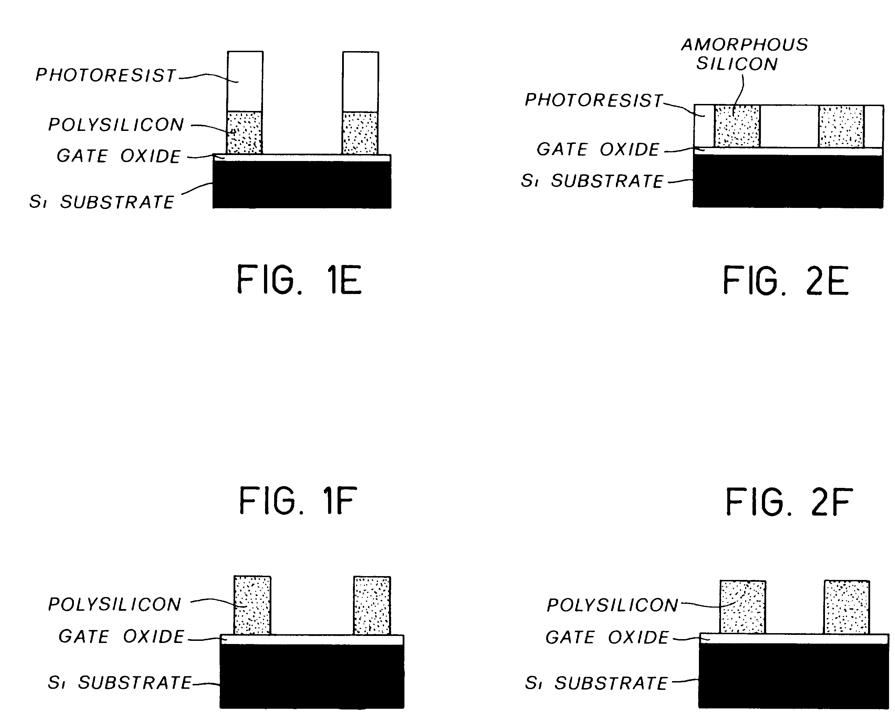

As it is known, the conventional process for producing the polysilicon gate structures of MOS transistors consists in various steps which are effected in predetermined sequence. In the first place, a thermal growing step is carried out upon the silicon substrate which is (also designated as wafer) so as to grow a silicon oxide layer of optimum quality to form the so-called gate oxide (Figure 1A). As a second step, a layer of polycrystalline silicon or polysilicon is deposited at high temperature (Figure 1B). Since this layer is intended to operate as a conductive layer, a phosphorous doping step is then carried out in order to lower its resistance (Figure 1C). At this point, a photolithographic process is carried out in order to transfer a well defined drawing or figure (pattern) to a photoresist layer (photoresponsive element resistant to chemical or plasma etching) in order to realize a mask for use in subsequent process steps. In effect this operation comprises a deposition stage to form a layer of photoresist material, then a proper patterning stage, namely an exposition stage of a photosensitive layer to an image of the pattern to be obtained with a subsequent development stage to fix the developed pattern and lastly a dissolution stage of the not fixed photoresist material, so as to leave the desired resistant photoresist material pattern (Figure 1D). As above mentioned, this pattern of resistant photoresist material will be used as a mask in order to obtain, in the underlying polysilicon layer, an identical pattern as the pattern realized in the photoresist material layer. In view of this, a plasma etching step is performed, aimed at removing all polysilicon, except the polysilicon protected by the overlaying patterned mask of fixed photoresist material (Figure 1E)

Lastly, after the plasma etching is complete, a particular chemical cleaning treatment is carried out aimed at removing the photoresist pattern, the function of which can be considered as effectively completed, as well as any further contaminant particles still existing on the disc or wafer, so as to exclusively leave the desired polysilicon pattern, by which the conductive gate lines are formed.

This conventional process is intrinsically efficient and generally carried out, but however, it is to be admitted that it still has some aspects that could be further improved, so as to eliminate some drawbacks.

For instance, some times it can be observed that some polysilicon lines are not perfectly insulated from one another, with consequent risk of short circuit developing therebetween.

Furthermore, it can be observed that the gate oxide layer is damaged by exposition to ion bombardment in the presence of a plasma or due to charge effects. In fact, said gate oxide layer is exposed not only to an etching step aimed at removing said polysilicon in order to pattern it, but to a milder additional etching treatment aimed at removing the photoresist material pattern and at cleaning the product (Figure 1F).

Upon closely considering these drawbacks, it is an object of this invention to propose an improved method adapted to eliminate the above mentioned negative aspects, as well as to enable further advantages to be obtained with respect to the above set forth conventional method.

This object is achieved according to this invention by means of a method for producing doped polysilicon patterns on silicon wafers, particularly for producing gate structures for MOS transistors. The method includes the following steps:
forming an insulating region over a surface of said substrate; forming a first masking region over said insulating region; transferring a pattern complementary to the desired patterned region to said first masking region and removing undesired portions of the first masking region; forming a conductive region over said patterned region and over said insulating region in regions corresponding to said removed portions of said first masking region; forming a second masking region over said conductive region; planarizing said second masking region, remaining portions of said first masking region and portions of said conductive region to form a substantially planar surface of said substrate; and removing said remaining portions of said first masking region thereby leaving only said planarised conductive region.

The present invention will now be further described, by way of example, with reference to the accompanying drawings in which:
Figures 1A-1F show in schematic and enlarged form the steps carried out in a conventional process according the state of the art; and
Figures 2A-2F show in schematic and enlarged form the steps carried out in the process according to the invention.

By referring now to Figures 2A-2F the process according to this invention will be described in its essential stages.

By referring to Figure 2A, it can be observed that the first step of the process is the same as the first step carried out in the conventional process and provides for growing a layer of silicon oxide, as gate oxide.

By referring to Figure 2B, it can be observed that, by means of a photolitographic process, it is provided for transferring a configuration or pattern to a layer of photoresist or other photosensitive material, said pattern being complementary to the pattern which is desired as an end result and, as such, complementary to the conventional one (negative configuration or pattern). As a matter of fact, this stage includes a step for deposition of a photoresist material layer, then a real patterning step, namely a step including the exposition of the photosensitive layer to a (complementary) image of the pattern which is desired as an end result, with subsequent development thereof for fixing said pattern and lastly a dissolution step of any not fixed photoresist material, so as to leave a pattern of resistant photoresist material, complementary to the pattern which is desired as an end result, on the gate oxide layer.

As far as the details of the photoresist or photosensitive materials to be used are concerned, as well as the removal or etching procedures to be carried out to remove or etch either the so fixed photoresist pattern or the polysilicon, they can be easily trimmed by those skilled in the art so as to fulfill the requirements of the various users.

As it is shown in Figure 2C, once the pattern is transferred to the photoresist or photosensitive material layer, it is provided for deposition of amorphous polysilicon, doped with phosphorous during the deposition itself, in order to completely cover the so obtained pattern of photoresist or photosensitive material.

The deposition temperature should be suitably adjusted as a function of the intrinsic thermal resistance characteristics of the material by which the lithographic mask is made.

It is subsequently provided for carrying out a deposition step of a photoresist material layer upon the phosphorous-doped, amorphous polysilicon layer, such as it is shown in Figure 2D.

Then, as it can be observed in Figure 2E, an etching step is carried out on the photoresist material and on the polysilicon, so as to planarize the surface of the wafer under treatment and to reduce any unevenesses to an acceptable level, for instance to less than 3%. Aiming at reaching this result, the removal rates of photoresist material and of silicon should be the same, which requires that the attack selectivity ratio for these two materials be 1. It can be clearly realized from Figure 2 that, after this attack, the wafer surface will have a set of polysilicon lines according to the desired (positive) pattern separated from one another by a set of photoresist/photosensitive material lines according to the complementary pattern.

As a final essential step, by referring to Figure 2F, the wafer is attacked by a suitable method, such as an oxygen plasma, in order to completely remove any photoresist/photosensitive material, thereby leaving only the amorphous-doped polysilicon lines, according to the desired pattern.

In conclusion, any short circuit possibility between the polysilicon lines or filaments is eliminated, in view of the fact that such lines are no more realized by removal of intermediate polysilicon, as it occurs in the prior art methods, but on the contrary, they are realized by deposition of silicon within already prepared and already separated recesses.

Furthermore, no damage of the gate oxide occurs, as it is caused by ion bombardment in the presence of plasma or due to charge effects, in view of the fact that the sole step by which the gate oxide layer is uncovered is the photoresist/photosensitive material removal step, which is much less demanding step than the doped polysilicon removal step, as it is carried out in the traditional method.

The photolitographic procedure by which the (complementary) pattern is realized in the photoresist/photosensitive material layer is noticeably simplified, in view of the lower reflectivity rate of the gate oxide with respect to polysilicon. Furthermore, still within the frame of this method, it is easier to realize vertical gate profiles, because it is easier to obtain vertical profiles in a pattern realized in a photoresist/photosensitive material, than in a pattern realized in a doped polysilicon layer.

Those skilled in the art will appreciate that no "microloading" effects are caused in the method according to this invention.

Lastly, two further advantages are apparent from the previous discussion. Namely, the possibility to use very simple etching methods, with removal of any gas particularly adapted to raise contamination problems or particulates of any kind, as well as the possibility to simplify the cleaning procedures after the so obtained gate lines have been defined. Both these advantages are achieved as a consequence of the fact that any criticality of the process connected with the definition of the lines by removal of polycrystalline silicon, as it occurred in the prior art, has been relayed to removal of photoresist/photosensitive material, which can be carried out by means of less critical methods.

The preferred embodiment of this invention has been hereinbefore explained and some changes have been suggested, but it should be understood that those skilled in the art can made further variations and changes therein without departing from the scope of this invention.

## Claims

1. A method for producing a pattern region on a substrate comprising the steps of;
forming an insulating region over a surface of said substrate; forming a first masking region over said insulating region; transferring a pattern complementary to the desired patterned region to said first masking region and removing undesired portions of the first masking region; forming a conductive region over said patterned region and over said insulating region in regions corresponding to said removed portions of said first masking region; forming a second masking region over said conductive region; planarizing said second masking region, remaining portions of said first masking region and portions of said conductive region to form a substantially planar surface of said substrate; and removing said remaining portions of said first masking region thereby leaving only said planarised conductive region.

2. The method as claimed in Claim 1, wherein the step of forming the insulating region comprises thermally growing a layer of silicon oxide.

3. The method as claimed in Claim 1 or Claim 2, wherein the step of forming the first masking layer comprises forming a layer of photoresist or other photosensitive material.

4. The method as claimed in any preceding claim, wherein the transferring step comprises performing a photolithographic process.

5. The method as claimed in any preceding claim, wherein the step of forming the conductive region comprises depositing phosphorous doped amorphous silicon to cover said patterned region.

6. The method as claimed in any preceding claim, wherein the step of forming the second masking region comprises depositing photoresist material at least on said conductive region.

7. The method as claimed in any preceding claim, wherein said planarizing step comprises etching said first and second masking regions and said conductive region.

8. The method as claimed in any preceding claim, wherein said step of removing said remaining portions of said first masking region comprises etching said first masking region.

9. The method as claimed in Claim 8, wherein said step of etching said first masking region comprises etching said first masking region by means of an oxygen plasma.

10. The method as claimed in any preceding claim, wherein the transferring step comprises;
exposing portions of said first masking region to an image of the desired patterned region;
fixing exposed portions of said first masking region; and
removing portions of said first masking region that are not fixed.

11. The method according to any preceding claim, further comprising performing said planarizing step until anomalies in the surface of said substrate account for less than 3%.

12. The method as claimed in any preceding claim further comprising selecting an etchant for performing said planarizing and etching steps that removes said first and second masking regions and said conductive region at the same rate.

13. The method as claimed in any preceding claim, further comprising performing said steps of forming said insulating region, forming said first masking region, transferring said pattern, forming said conductive region, forming said second masking region, planarizing said second masking region and removing remaining portions of said first masking region to produce a doped polysilicon pattern for a gate structure of a MOS transistor.

14. A device formed according to the method of any Claims 1 to 13.

15. The device as claimed in Claim 14, wherein the device is a MOS transistor.
